# EUROPEAN PATENT APPLICATION

(11) **EP 4 557 753 A1**
(43) Date of publication of application: **21.05.2025**
(21) Application number: 24212528.4
(22) Date of filing: 12.11.2024
(51) Int. Cl.: H04N 23/00

(54) **ELECTRO-MAGNETIC INTERFERENCE SHIELDING FOR CAMERA MODULE**

(30) Priority: 14.11.2023 US 202363548454 P; 18.10.2024 US 202418920695
(71) Applicant: Meta Platforms Technologies, LLC, Menlo Park, CA 94025 (US)
(72) Inventor: Tam, Samuel, Menlo Park (US)
(74) Representative: Murgitroyd & Company

(57) **Abstract**

A camera module includes a routing substrate, an image sensor, electrical components, molding compound, and an electro-magnetic interference (EMI) shield layer. The routing substrate has a ground plane coupled between a first side of the routing substrate and a second side of the routing substrate. The image sensor is configured to receive incident image light. The electrical components are electrically coupled to the second side of the routing substrate. The molding compound supports the image sensor and supports the electrical components. The EMI shield layer is disposed on the molding compound and the EMI shield layer is tied to the ground plane of the routing substrate.

## Description

### TECHNICAL FIELD

This disclosure relates generally to optics, and in particular to cameras.

### BACKGROUND INFORMATION

Cameras are ubiquitous in consumer electronics. For example, smart phones, tablets, action-cameras, laptops, and even monitors may incorporate a camera. Typically, the cameras that are incorporated into consumer electronics include a lens assembly paired with a complementary metal-oxide semiconductor (CMOS) image sensor to capture a color image. It is desirable to shrink the size of cameras and include features that protect the cameras from adverse environmental factors.

### SUMMARY

According to an aspect, there is provided a camera module comprising:
a routing substrate having a ground plane coupled between a first side of the routing substrate and a second side of the routing substrate;
an image sensor configured to receive incident image light, wherein the image sensor is electrically coupled to the first side of the routing substrate;
electrical components electrically coupled to the second side of the routing substrate;
molding compound supporting the image sensor and supporting the electrical components; and
an electro-magnetic interference, EMI, shield layer disposed on the molding compound, wherein the EMI shield layer is tied to the ground plane of the routing substrate.

The EMI shield layer may include metal.

The EMI shield layer may include at least one of copper or stainless steel.

The EMI shield layer may include:
a first metal adhesion-layer configured to adhere to the molding compound;
a second metal shielding-layer configured to shield the camera module from electro-magnetic interference; and
a third metal protection layer configured to shield the EMI shield layer from an environment of the camera module.

The ground plane of the routing substrate may be exposed on ends of the routing substrate. The EMI shield layer may be electrically coupled to the ground plane on ends of the routing substrate.

The ground plane of the routing substrate may be electrically insulated on ends of the routing substrate. The EMI shield layer may be electrically coupled to the ground plane through a solder mask on the second side of the routing substrate.

The camera module may further comprise vias running through the molding compound. The vias may electrically couple the ground plane to the EMI shield layer.

At least a portion of the vias may be disposed between the electrical components on the second side of the routing substrate.

The camera module may further comprise wires of a bonded via array, BVA, running through the molding compound. The wires may electrically couple the ground plane to the EMI shield layer.

At least a portion of the wires of the BVA may be disposed between the electrical components on the second side of the routing substrate. The routing substrate may include vias running to the ground plane to support the BVA. The wires of the BVA may be inserted and electrically coupled to the vias of the routing substrate.

According to another aspect, there is provided a method of fabricating a camera module comprising:
electrically coupling an image sensor to a first side of a routing substrate having a ground plane disposed between the first side and a second side of the routing substrate; and
depositing an electro-magnetic interference, EMI, shield layer on a molding compound that supports the image sensor and electrical components electrically coupled to a second side of a routing layer,
wherein depositing the EMI shield layer electrically couples the EMI shield layer to the ground plane of the routing substrate.

The method may include:
singulating, the camera module from other camera modules disposed on a common routing substrate, wherein the singulating exposes the ground plane of the routing substrate on ends of the routing substrate so that the EMI shield layer can be electrically tied to the ground plane of the routing substrate.

Singulating may be caused by a laser singulation technique.

The method may include:
forming vias in the molding compound prior to depositing the EMI shield layer. The vias may run through the molding compound to the ground plane of the routing substrate.

The vias may be laser-drilled vias.

The method may include depositing the EMI shield layer fills the vias to electrically tie the EMI shield layer to the ground plane.

The method may include plating the vias with an electrical conductor prior to depositing the EMI shield layer, wherein the electrical conductor filling the vias electrically ties the EMI shield layer to the ground plane of the routing substrate.

Depositing the EMI shield layer may include:
depositing the EMI shield layer to cover the molding compound supporting the electrical components coupled to the second side of the routing substrate;
curing the EMI shield layer covering the molding compound supporting the electrical components; and
depositing the EMI shield layer to cover the molding compound supporting the image sensor on the first side of the routing substrate subsequent to curing the EMI shield layer covering the molding compound supporting the electrical components.

The method may include forming a bonded via array, BVA, by inserting wires into vias of the routing substrate prior to depositing the EMI shield layer, wherein the vias are electrically tied to the ground plane of the routing substrate, and wherein depositing the EMI shield layer electrically couples the EMI shield layer to the BVA.

The EMI shield layer may contact the molding compound.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### BRIEF DESCRIPTION OF THE DRAWINGS

Non-limiting and non-exhaustive embodiments of the invention are described with reference to the following figures, wherein like reference numerals refer to like parts throughout the various views unless otherwise specified.
FIG. 1 illustrates an example camera module having a metal lid as an Electro-magnetic Interference (EMI) lid.
FIG. 2 illustrates a camera module including an image sensor and an EMI shield layer disposed on a molding compound of the camera module, in accordance with aspects of the disclosure.
FIG. 3 illustrates an example process of fabricating a camera module, in accordance with aspects of the disclosure.
FIG. 4 illustrates a camera module including an image sensor and an EMI shield layer disposed on molding compound of the camera module, in accordance with aspects of the disclosure.
FIG. 5 illustrates an example process of fabricating a camera module that includes laser-drilling vias, in accordance with aspects of the disclosure.
FIG. 6 illustrates a camera module including an EMI shield layer coupled to bonded via arrays (BVA), in accordance with aspects of the disclosure.
FIG. 7 illustrates an example multi-layer EMI shield layer, in accordance with aspects of the disclosure.
FIG. 8 illustrates an example process of fabricating a camera module using bonded via arrays (BVA), in accordance with aspects of the disclosure.
FIG. 9 illustrates a flow chart of an example process of fabricating a camera module with an EMI shield, in accordance with aspects of the disclosure.

### DETAILED DESCRIPTION

Embodiments of electro-magnetic interference (EMI) shields for a camera modules are described herein. In the following description, numerous specific details are set forth to provide a thorough understanding of the embodiments. One skilled in the relevant art will recognize, however, that the techniques described herein can be practiced without one or more of the specific details, or with other methods, components, materials, etc. In other instances, well-known structures, materials, or operations are not shown or described in detail to avoid obscuring certain aspects.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

Throughout this specification, several terms of art are used. These terms are to take on their ordinary meaning in the art from which they come, unless specifically defined herein or the context of their use would clearly suggest otherwise.

In aspects of this disclosure, visible light may be defined as having a wavelength range of approximately 380 nm - 700 nm. Non-visible light may be defined as light having wavelengths that are outside the visible light range, such as ultraviolet light and infrared light. Infrared light having a wavelength range of approximately 700 nm - 1 mm includes near-infrared light. In aspects of this disclosure, near-infrared light may be defined as having a wavelength range of approximately 700 nm - 1.6 µm.

In aspects of this disclosure, the term "transparent" may be defined as having greater than 90% transmission of light. In some aspects, the term "transparent" may be defined as a material having greater than 90% transmission of visible light.

Electro-magnetic Interference (EMI) shielding for camera modules is desirable to preserve image signals and prevent the camera module from being harmed from electrostatic discharge (ESD), among other reasons. Existing approaches include attaching an EMI lid to a printed circuit board that a camera module is electrically coupled to. However, gaps between the camera module and the EMI lid increase the size of the camera module as well as adding another part to the bill of materials. Additionally, attaching the EMI lid requires another process step and monitoring tolerances of the EMI lid.

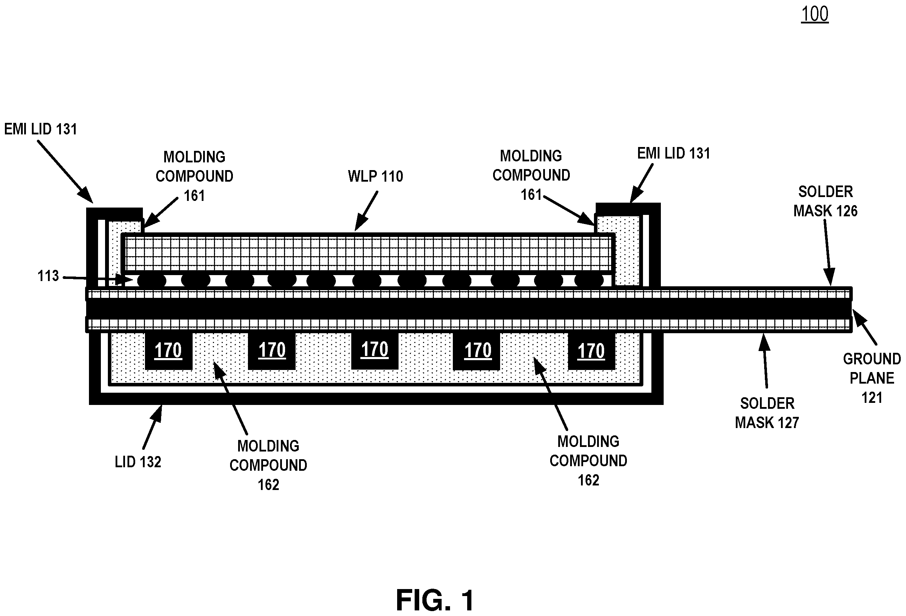

FIG. 1 illustrates an example camera module 100 having a metal lid as an EMI lid 131. The EMI lid 13 may be made of stainless steel. Notably, there are gaps between the EMI lid 131 and the molding compound 161 that surrounds the image sensor 110 so that the EMI lid 131 has enough clearance to be assembled over the molding compound 161 and 162. The image sensor 110 is shown as a wafer level package (WLP) with solder balls 113 electrically coupling the image sensor 110 to a routing substrate (e.g. printed circuit board) that includes a copper ground plane 121 and a first solder mask 126 on the first side of the routing substrate and a second solder mask 127 on the second side of the routing substrate. In FIG. 1, electrical components 170 are shown as surface mount technology (SMT) components supported by molding compound 162.

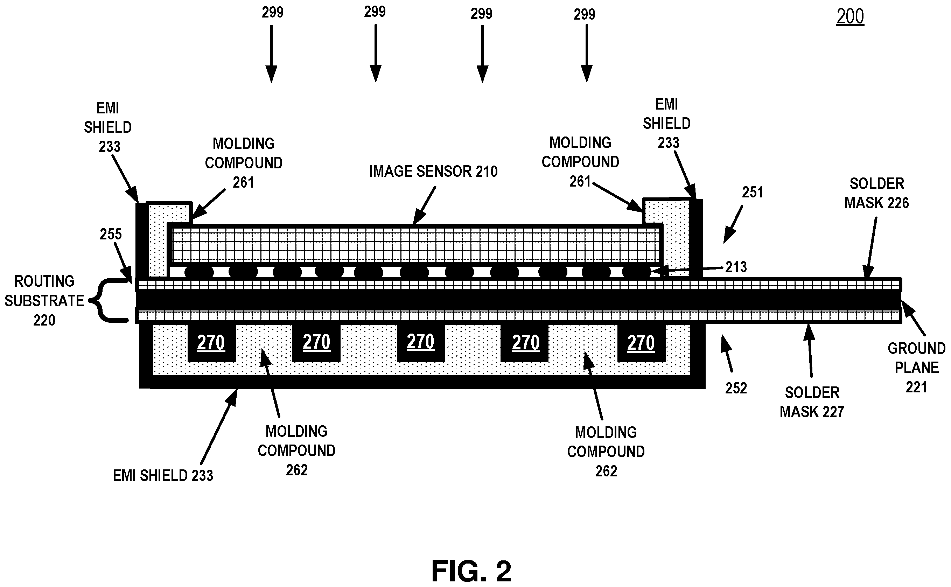

FIG. 2 illustrates a camera module 200 including an image sensor 210 and an EMI shield layer 233 disposed on molding compound 261 of the camera module 200, in accordance with aspects of the disclosure. Routing substrate 220 includes a ground plane 221 (e.g. copper) coupled between a first side 251 of the routing substrate 220 and a second side 252 of the routing substrate 220. The image sensor 210 is configured to receive incident light 299 and is electrically coupled to the first side 251 of routing substrate 220. In the illustrated example, image sensor 210 is electrically coupled to the first side 251 of routing substrate 220 by way of solder balls 213. Image sensor 210 may include a complementary metal-oxide semiconductor (CMOS) image sensor in a wafer level package (WLP). Image sensor 210 may include an array of CMOS imaging pixels arranged in rows and columns configured to capture a digital image.

Electrical components are shown as surface mount technology (SMT) components 270 supported by bottom molding compound 262. The electrical components 270 may be passive (e.g. resistor, inductor, capacitor) or active (e.g. transistors), for example. The electrical components may be electrically coupled to image sensor 210 to support the functionality of image sensor 210. For example, capacitors may assist in suppressing noise from power rails provided to the image sensor 210. In the illustration of FIG. 2, top molding compound 261 supports the image sensor 210 and bottom molding compound 262 supports the electrical components 270. Top molding compound 261 may surround image sensor 210 to secure and protect image sensor 210. Molding compound 261 may overhang a small portion of image sensor 210 to assist in securing image sensor 210 to routing substrate 220 and the camera module 200, in general, as illustrated in FIG. 2. The molding compound 262 may surround and/or encapsulate the electrical components 270 to protect them from the environment and/or to add mechanical support. The molding compounds 261 and 262 may be an electrical insulator.

Camera module 200 includes an EMI shield layer 233 disposed on molding compound 261 and 262. EMI shield layer 233 is tied to the ground plane 221 of routing substrate 220, in FIG. 2. EMI shield layer 233 is disposed on the top molding compound 261 on the first side 251 and disposed on the bottom molding compound 262 of the second side 252 of the routing substrate 220. EMI shield layer 233 includes metal. The metal may include copper or stainless steel, or both.

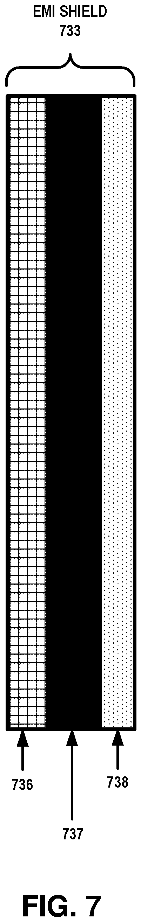

In some implementations, EMI shield layer 233 includes multiple layers. FIG. 7 illustrates an example EMI shield layer 733 that may be used as an EMI shield layer, in accordance with aspects of the disclosure. Example EMI shield layer 733 includes a first metal adhesion-layer 736 configured to adhere to molding compound (e.g. molding compound 261 and 262), a second metal shielding-layer 737 configured to shield a camera module (e.g. camera module 200) from electro-magnetic interference, and a third metal protection layer 738 configured to shield the EMI shield layer 733 from an environment surrounding the camera module. The second metal shielding-layer 737 may be copper and the first metal adhesion-layer 736 and the third metal protection layer 738 may be stainless steel. The second metal shielding-layer 737 may be approximately 0.05 microns and the first metal adhesion-layer 736 and the third metal protection layer 738 may be stainless steel having a thickness of approximately 0.03 microns.

Referring again to FIG. 2, in an implementation, the ground plane 221 of the routing substrate 220 is exposed on one or more ends 255 of the routing substrate 220 so that EMI shield layer 233 is electrically coupled to the ground plane 221 on the end 255 of the routing substrate 220. In some implementations, ground plane 221 of routing substrate 220 is exposed around the whole routing substrate 221 and the EMI shield layer 233 surrounds the ground plane 221. The ground plane 221 may be exposed for the EMI shield layer 233 to be deposited on after a singulation (e.g. laser singulation) of the camera module 200 from other camera modules. In other words, the singulation of the camera modules may cause the exposure of ground plane 221.

In an implementation, the ground plane 221 of the routing substrate 220 is electrically insulated on one or more ends 255 of the routing substrate and the EMI shield layer 233 is electrically coupled to the ground plane 221 of the routing substrate 220 through a solder mask on the second side 252 of the routing substrate 220.

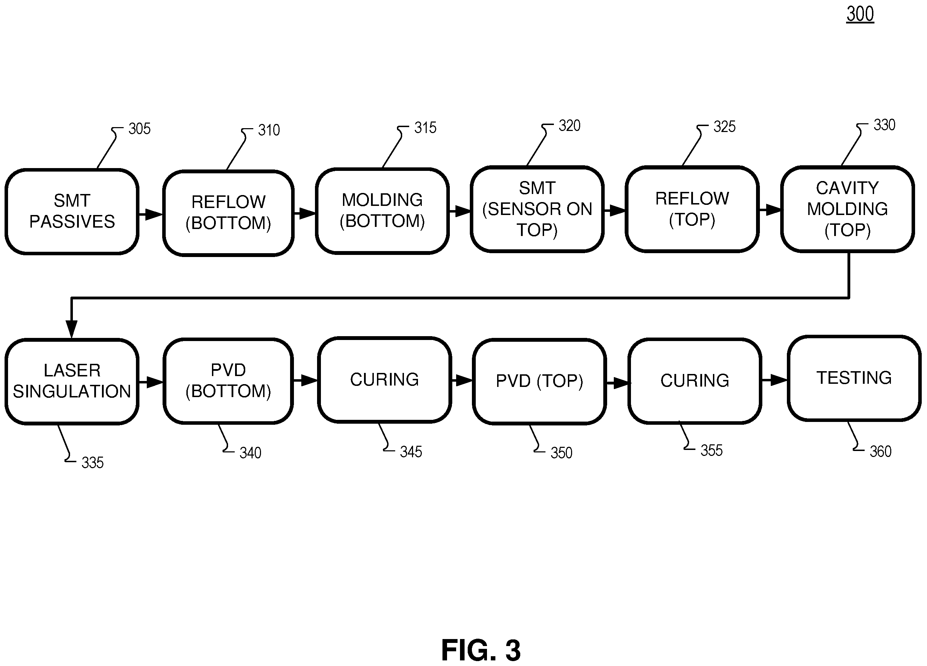

FIG. 3 illustrates an example process 300 of fabricating a camera module, in accordance with aspects of the disclosure. FIG. 3 shows a physical vapor deposition (PVD) process may be used for sputtering different coatings to form the EMI shield layer 233 on the molding compound surface to connect to the ground plane. FIG. 3 shows that the PVD technique may be utilized for the bottom side of the camera module (e.g. side 252 in FIG. 2) and then the top side of the camera module 200 (e.g. side 251). The order in which some or all of the process blocks appear in FIG. 3 should not be deemed limiting. Rather, one of ordinary skill in the art having the benefit of the present disclosure will understand that some of the process blocks may be executed in a variety of orders not illustrated, or even in parallel.

In process block 305, surface mount technology (SMT) passive components are provided. Components 270 may be SMT passive components, for example. In process block 310, the bottom of the structure is reflowed to electrically couple the SMT passive components to second side 252 of routing substrate 220. In process block 315, molding compound 262 may be formed.

In process block 320, SMT components (including sensor 210) may be provided. In process block 325, the top of the structure is reflowed to electrically couple the SMT components provided in process block 320 to first side 251 of routing substrate 220. In process block 315, molding compound 261 may be formed.

In process block 335, a laser may be used to singulate a camera module (e.g. camera module 200) from other camera modules that share a common substrate. A Physical Vapor Deposition (PVD) technique may be used to deposit one or more layers of an EMI shield on a bottom (e.g. same as side 252) of the camera module, in process block 340. The PVD process technique may include sputtering. As a result of the PVD process, the EMI shield may be electrically coupled to a ground plane 221 of substrate 220. In examples where the EMI shield includes multiple layers, multiple rounds of PVD may be employed to deposit each layer of the EMI shield. In process block 345, the EMI shield may be cured.

A Physical Vapor Deposition (PVD) technique may be used to deposit one or more layers of an EMI shield on a top (e.g. same as side 251) of the camera module, in process block 350. Image sensor 210 and other components on the top of the camera module may be masked off prior to process block 350 so that the deposition process does not affect certain components or portions of the component. The PVD process technique may include sputtering. As a result of the PVD process, the EMI shield may be electrically coupled to a ground plane 221 of substrate 220. In examples where the EMI shield includes multiple layers, multiple rounds of PVD may be employed to deposit each layer of the EMI shield. In process block 355, the EMI shield may be cured. In process block 360, the camera module that includes the EMI shield may be tested for electrical functionality.

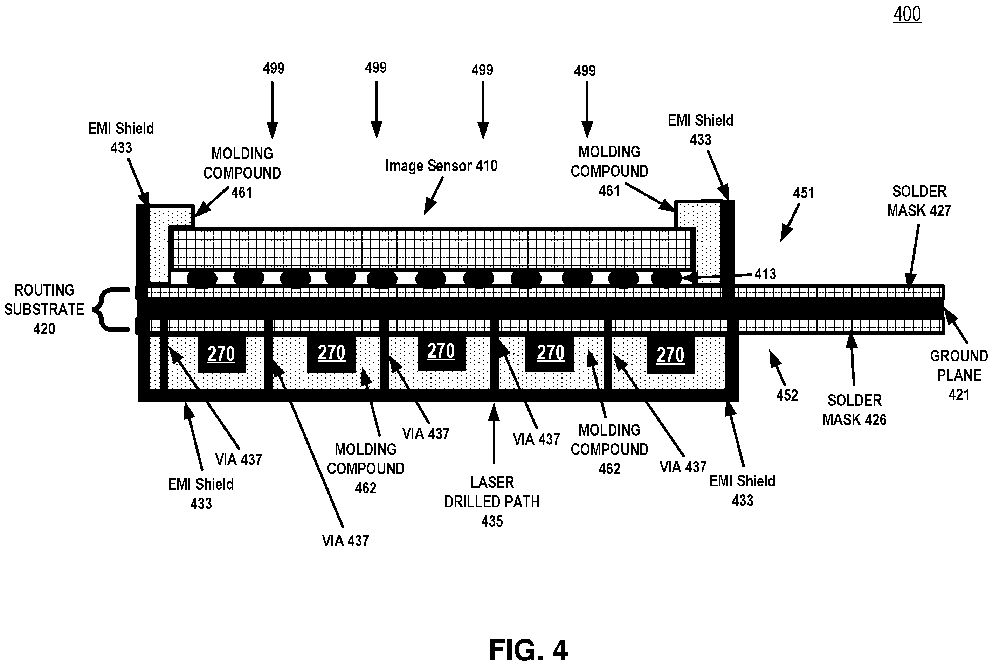

FIG. 4 illustrates a camera module 400 including an image sensor 410 and an EMI shield layer 433 disposed on molding compound 461 and 462 of the camera module 400, in accordance with aspects of the disclosure.

Routing substrate 420 includes a ground plane 421 (e.g. copper) coupled between a first side 451 of the routing substrate 420 and a second side 452 of the routing substrate 420. The image sensor 410 is configured to receive incident light 499 and is electrically coupled to the first side 451 of routing substrate 420. In the illustrated example, image sensor 410 is electrically coupled to the first side 451 of routing substrate 420 by way of solder balls 413. Image sensor 410 may include a complementary metal-oxide semiconductor (CMOS) image sensor in a wafer level package (WLP). Image sensor 410 may include an array of CMOS imaging pixels arranged in rows and columns configured to capture a digital image.

Electrical components are shown as SMT components 270 supported by molding compound 462. The electrical components may be passive (e.g. resistor, inductor, capacitor) or active (e.g. transistors). The electrical components may be electrically coupled to image sensor 410 to support the functionality of image sensor 410. For example, capacitors may assist in suppressing noise from power rails provided to the image sensor 410. In the illustration of FIG. 4, molding compound 461/462 supports the image sensor 410 and the electrical components. Top molding compound 461 may surround image sensor 410 to secure and protect image sensor 410. Top molding compound 461 may overhang a small portion of image sensor 410 to assist in securing image sensor 410 to routing substrate 420 and the camera module 400, in general, as illustrated in FIG. 4. The molding compound 462 may surround and/or encapsulate the electrical components to protect them from the environment and/or to add mechanical support. The molding compound 461/462 may be an electrical insulator.

Camera module 400 includes an EMI shield layer 433 disposed on the molding compound 461/462. EMI shield layer 433 is tied to the ground plane of routing substrate 420. EMI shield layer 433 is disposed on the molding compound 461/462 on the first side 451 and the second side 452 of the routing substrate 420. EMI shield layer 433 includes metal. The metal may include copper or stainless steel, or both.

In some implementations, EMI shield layer 433 includes multiple layers. FIG. 7 illustrates an example EMI shield layer 733 that may be used as EMI shield layer 433, in accordance with aspects of the disclosure. In one implementation, EMI shield layer 433 includes a first metal adhesion-layer configured to adhere to the molding compound, a second metal shielding-layer configured to shield the camera module 400 from electro-magnetic interference, and a third metal protection layer configured to shield the EMI shield layer 433 from an environment of the camera module 400. The second metal shielding-layer may be copper and the first metal adhesion-layer and the third metal protection layer may be stainless steel. The second metal shielding-layer may be approximately 0.05 microns and the first metal adhesion-layer and the third metal protection layer may be stainless steel having a thickness of approximately 0.03 microns.

In FIG. 4, the EMI shield layer 433 is electrically coupled to the ground plane of routing substrate 420 by vias 437 running through molding compound 462. At least a portion of the vias 437 are disposed between the electrical components 270 on the second side 452 of the routing substrate 420.

The vias 437 may be created by laser drilling through the molding compound 462 along example laser drilled path 435 to the ground plane 421 of routing substrate 420. The vias 437 may be "plated-up" using nickel and/or gold plating techniques to provide electrical contact between EMI shield layer 433 and the ground plane421. In some implementations, the vias 437 are approximately 20 microns in diameter. In some implementations, the vias 437 are filled with the metals (e.g. stainless steel and/or copper) in the PVD process and the vapor deposition of the metals within the vias 437 provide the electrical contact between the ground plane 421 and the EMI shield layer 433.

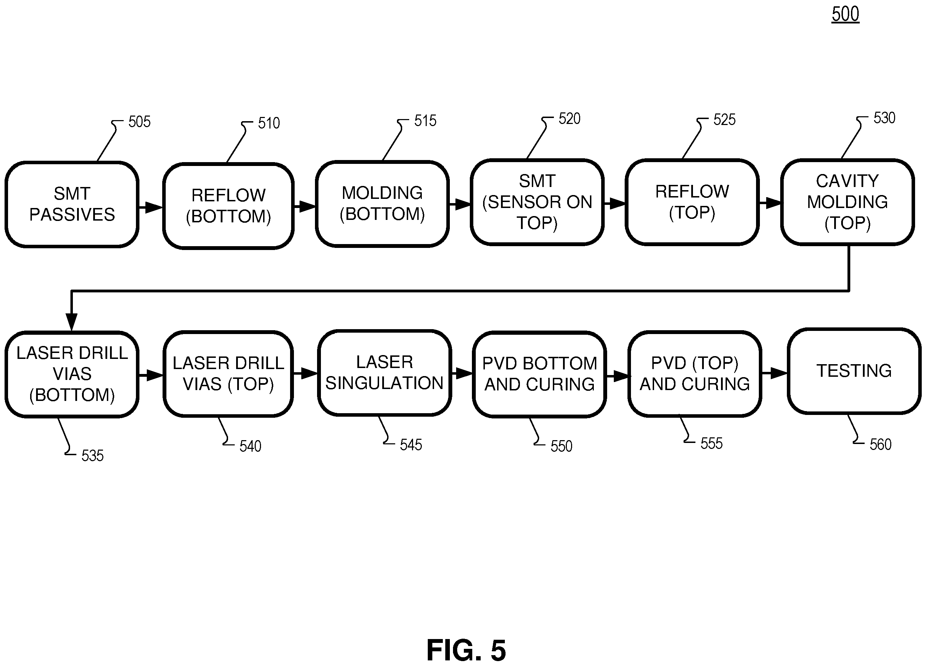

FIG. 5 illustrates an example process 500 of fabricating a camera module, in accordance with aspects of the disclosure. The order in which some or all of the process blocks appear in FIG. 5 should not be deemed limiting. Rather, one of ordinary skill in the art having the benefit of the present disclosure will understand that some of the process blocks may be executed in a variety of orders not illustrated, or even in parallel. FIG. 5 shows a laser-drilling of vias in order to connect the EMI shield to the ground plane through the molding compound.

In process block 505, surface mount technology (SMT) passive components are provided. Components 270 may be SMT passive components, for example. In process block 510, the bottom of the structure is reflowed to electrically couple the SMT passive components to second side 452 of routing substrate 420. In process block 515, molding compound 462 may be formed.

In process block 520, SMT components (including sensor 410) may be provided. In process block 525, the top of the structure is reflowed to electrically couple the SMT components provided in process block 520 to first side 451 of routing substrate 420. In process block 530, molding compound 461 may be formed.

In process block 535, a laser may be used to drill vias 437 in molding compound 462. Multiple vias may be laser drill along a laser drill path such as example laser drill path 435. The laser drill paths may be orthogonal to routing substrate 420. Process block 540 shows that laser-drilled vias may also optionally be drilled through top molding compound 461.

In process block 545, a laser may be used to singulate a camera module (e.g. camera module 400) from other camera modules that share a common substrate.

In process block 550, a Physical Vapor Deposition (PVD) technique may be used to deposit one or more layers of an EMI shield on a bottom (e.g. same as side 452) of the camera module. The PVD process technique may include sputtering. In some implementations, the PVD process also deposits metal into the laser drilled holes to produce vias that ultimately connect ground plane 421 to EMI shield layer 433. In examples where the EMI shield includes multiple layers, multiple rounds of PVD may be employed to deposit each layer of the EMI shield. The metal plating of the vias (e.g. vias 437) and the EMI shield deposition may also be cured in process block 550.

A Physical Vapor Deposition (PVD) technique may be used to deposit one or more layers of an EMI shield on a top (e.g. same as side 451) of the camera module, in process block 555. Image sensor 410 and other components on the top of the camera module may be masked off prior to process block 555 so that the deposition process does not affect certain component or portions of the component. The PVD process technique may include sputtering. As a result of the PVD process, the EMI shield may be electrically coupled to a ground plane 421 of substrate 420. In examples where the EMI shield includes multiple layers, multiple rounds of PVD may be employed to deposit each layer of the EMI shield. In process block 560, the camera module that includes the EMI shield may be tested for electrical functionality.

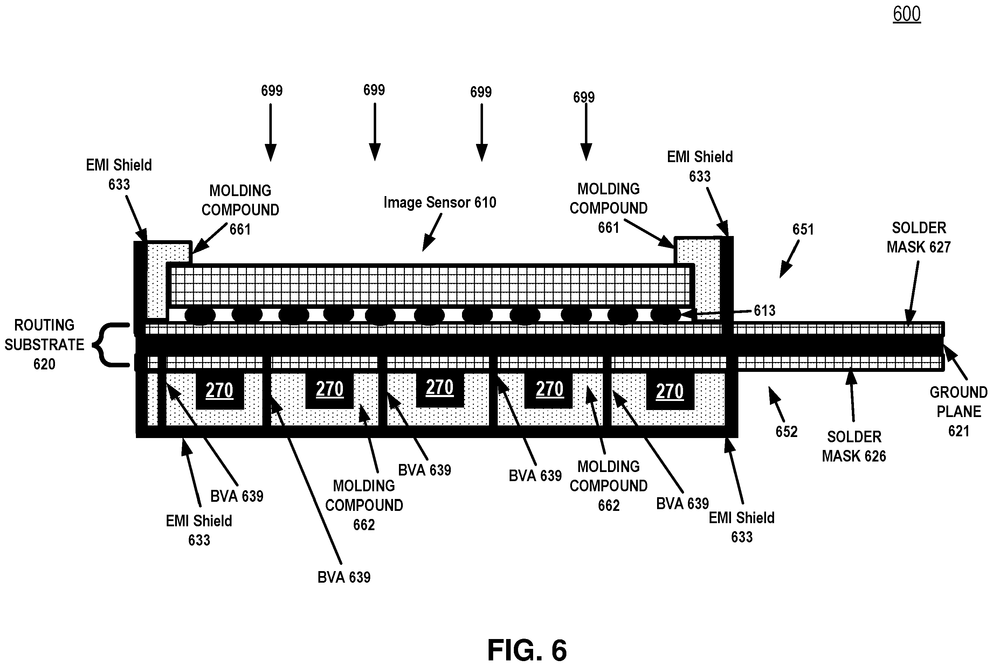

FIG. 6 illustrates a camera module 600 including an EMI shield layer 633 coupled to bonded via arrays (BVA) 639, in accordance with aspects of the disclosure. Routing substrate 620 includes a ground plane 621b(e.g. copper) coupled between a first side 651 of the routing substrate 620 and a second side 652 of the routing substrate 620. The image sensor 610 is configured to receive incident light 699 and is electrically coupled to the first side 651 of routing substrate 620. In the illustrated example, image sensor 610 is electrically coupled to the first side 651 of routing substrate 620 by way of solder balls 613. Image sensor 610 may include a complementary metal-oxide semiconductor (CMOS) image sensor in a wafer level package (WLP). Image sensor 610 may include an array of CMOS imaging pixels arranged in rows and columns configured to capture a digital image.

Electrical components are shown as surface mount technology (SMT) components 270 supported by molding compound 662. The electrical components may be passive (e.g. resistor, inductor, capacitor) or active (e.g. transistors). The electrical components may be electrically coupled to image sensor 610 to support the functionality of image sensor 610. In the illustration of FIG. 6, molding compound 661/662 supports the image sensor 610 and the electrical components 270. Top molding compound 661 may surround image sensor 610 to secure and protect image sensor 610. Molding compound 661 may overhang a small portion of image sensor 610 to assist in securing image sensor 610 to routing substrate 620 and the camera module 600 in general, as illustrated in FIG. 6. The molding compound 662 may surround and/or encapsulate the electrical components to protect them from the environment and/or to add mechanical support. The molding compound 661/662 may be an electrical insulator.

Camera module 600 includes an EMI shield layer 633 disposed on the molding compound 661/662. EMI shield layer 633 is tied to the ground plane of routing substrate 620. EMI shield layer 633 is disposed on the molding compound 661/662 on the first side 651 and the second side 652 of the routing substrate 620. EMI shield layer 633 includes metal. The metal may include copper or stainless steel, or both.

In some implementations, EMI shield layer 633 includes multiple layers. FIG. 7 illustrates an example EMI shield layer 733 that may be used as EMI shield layer 633, in accordance with aspects of the disclosure. In one implementation, the EMI shield layer 633 includes a first metal adhesion-layer configured to adhere to the molding compound, a second metal shielding-layer configured to shield the camera module 600 from electro-magnetic interference, and a third metal protection layer configured to shield the EMI shield layer 633 from an environment of the camera module 600. The second metal shielding-layer may be copper and the first metal adhesion-layer and the third metal protection layer may be stainless steel. The second metal shielding-layer may be approximately 0.05 microns and the first metal adhesion-layer and the third metal protection layer may be stainless steel having a thickness of approximately 0.03 microns.

In FIG. 6, the EMI shield layer 633 is electrically coupled to the ground plane of routing substrate 620 by bonded via arrays (BVA) 639 running through the molding compound 662. At least a portion of the BVA 639 are disposed between the electrical components 270 on the second side 652 of the routing substrate 620. The BVA 639 may be orthogonal to routing substrate 620. The BVA 639 are electrically tied to the ground plane 621 of routing substrate 620. The BVA 639 may be fabricated using a wire bonder machine that inserts wire (e.g. copper or gold) into vias already formed in a printed circuit board. Routing substrate 620 may be implemented as including a printed circuit board having vias that the BVA can be inserted into. BVA technology is used in chip stacking solutions such as stacking processors chips to memory chips, for example. The pitch of the wires in the array may be 0.2-0.4 mm with the wire diameter being 0.025 mm to 0.05 mm, for example. A length of the wires of the BVA 639 protruding above the routing substrate 620 may be approximately 0.3-0.8 mm, for example. The wires of the BVA 639 are electrically coupled to the ground plane 621 of routing substrate 620 and EMI shield layer 633. The wires of BVA 639 also extract heat from the ground plane 621.

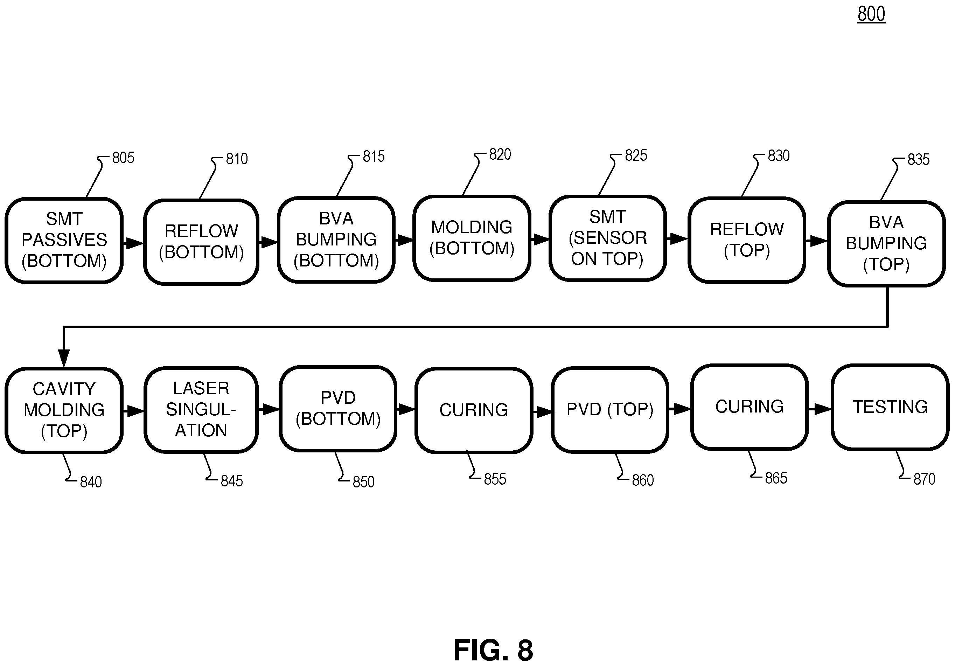

FIG. 8 illustrates an example process 800 of fabricating a camera module using BVA, in accordance with aspects of the disclosure. The order in which some or all of the process blocks appear in FIG. 8 should not be deemed limiting. Rather, one of ordinary skill in the art having the benefit of the present disclosure will understand that some of the process blocks may be executed in a variety of orders not illustrated, or even in parallel. FIG. 8 shows BVA being utilized with the routing substrate to connect the EMI shield to the ground plane through the molding compound. The metal of the EMI shield connects to the tops of the wires of BVA to electrically tie the EMI shield to the ground plane. The wires of the BVA may extend from the molding compound to be exposed for deposition of the metal of the EMI shield.

In process block 805, surface mount technology (SMT) passive components are provided. Components 270 may be SMT passive components, for example. In process block 810, the bottom of the structure is reflowed to electrically couple the SMT passive components to second side 652 of routing substrate 620. In process block 815, BVAs are formed on the second side 652 of routing substrate 620. In process block 820, molding compound 662 may be formed on the second side 652.

In process block 825, SMT components (including sensor 610) may be provided. In process block 830, the top of the structure is reflowed to electrically couple the SMT components provided in process block 825 to first side 651 of routing substrate 620. In process block 835, BVAs may be formed on the first side 651 of routing substrate 620. In process block 840, molding compound 661 may be formed on the first side 651.

In process block 845, a laser may be used to singulate a camera module (e.g. camera module 600) from other camera modules that share a common substrate.

In process block 850, a Physical Vapor Deposition (PVD) technique may be used to deposit one or more layers of an EMI shield on a bottom (e.g. same as side 652) of the camera module. The PVD process technique may include sputtering. In examples where the EMI shield includes multiple layers, multiple rounds of PVD may be employed to deposit each layer of the EMI shield. In process block 855, the EMI shield may be cured.

A Physical Vapor Deposition (PVD) technique may be used to deposit one or more layers of an EMI shield on a top (e.g. same as side 651) of the camera module, in process block 860. Image sensor 610 and other components on the top of the camera module may be masked off prior to process block 860 so that the deposition process does not affect certain component or portions of the component. The PVD process technique may include sputtering. As a result of the PVD process, the EMI shield may be electrically coupled to a ground plane 621 of routing substrate 620. In examples where the EMI shield includes multiple layers, multiple rounds of PVD may be employed to deposit each layer of the EMI shield. In process block 865, the EMI shield may be cured. In process block 870, the camera module that includes the EMI shield may be tested for electrical functionality.

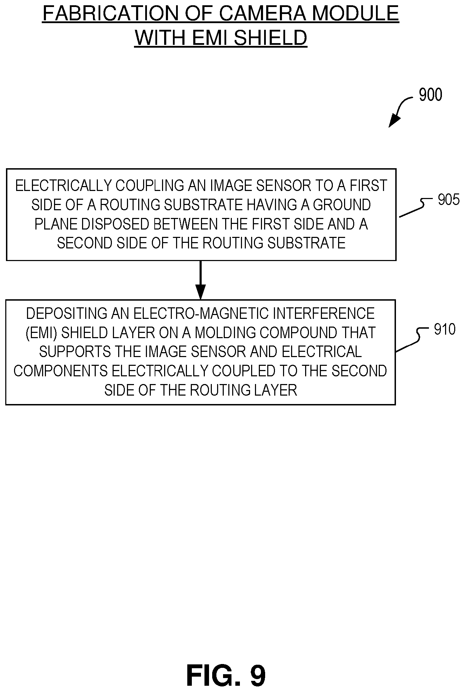

FIG. 9 illustrates a flow chart of an example process 900 of fabricating a camera module with an EMI shield, in accordance with aspects of the disclosure. The order in which some or all of the process blocks appear in process 900 should not be deemed limiting. Rather, one of ordinary skill in the art having the benefit of the present disclosure will understand that some of the process blocks may be executed in a variety of orders not illustrated, or even in parallel.

In process block 905, an image sensor is electrically coupled to a first side of a routing substrate having a ground plane disposed between the first side and a second side of the routing substrate.

In process block 910, an electro-magnetic interference (EMI) shield layer is deposited on a molding compound that supports the image sensor and the electrical components electrically coupled to a second side of the routing layer. Depositing the EMI shield layer electrically couples the EMI shield layer to the ground plane of the routing substrate. The EMI shield may contact the molding compound.

Some implementations of process 900 further include singulating the camera module from other camera modules disposed on a common routing substrate. The singulating exposes the ground plane of the routing substrate on ends of the routing substrate so that the EMI shield layer can be electrically tied to the ground plane of the routing substrate. The singulating may be caused by a laser singulation technique.

Some implementations of process 900 include forming vias in the molding compound prior to depositing the EMI shield layer where the vias run through the molding compound to the ground plane of the routing substrate. The vias may be laser-drilled vias. Depositing the EMI shield layer may fill the vias to electrically tie the EMI shield layer to the ground plane. In implementations, the vias are plated with an electrical conductor prior to depositing the EMI shield layer and the electrical conductor filling the vias electrically ties the EMI shield layer to the ground plane of the routing substrate.

In implementations of process 900, depositing the EMI shield layer in process block 910 includes (1) depositing the EMI shield layer to cover the molding compound supporting the electrical components coupled to the second side of the routing substrate; (2) curing the EMI shield layer covering the molding compound supporting the electrical components; and (3) depositing the EMI shield layer to cover the molding compound supporting the image sensor on the first side of the routing substrate subsequent to curing the EMI shield layer covering the molding compound supporting the electrical components.

Some implementations of process 900 include forming a bonded via array (BVA) by inserting wires into vias of the routing substrate prior to depositing the EMI shield layer where the vias are electrically tied to the ground plane of the routing substrate and depositing the EMI shield layer electrically couples the EMI shield layer to the BVA.

The implementations of the disclosure may significantly reduce the size of the camera module while also reducing the cost of using a dedicated EMI lid part. The deposited EMI shield layer disclosed may also increase the thermal dissipation of the image sensor and the corresponding electrical components because depositing the EMI shield layer 233/433/633 eliminates an air gap between those parts and an EMI lid. The drilled vias in FIG. 4 may also provide additional heat dissipation of the heat transferred from the image sensor to the ground plane (through the solder balls 413) since the drilled vias can extract the heat from the ground plane 421 to the EMI shield layer 433. The wires of the BVA 639 in FIG. 6 may also provide additional heat dissipation of the heat transferred from the image sensor to the ground plane (through the solder balls 613) since the wires can extract the heat from the ground plane to the EMI shield layer 633. Improvements to heat dissipation also improve image quality of the image signals captured by the image pixel array in the image sensor.

Embodiments of the invention may include or be implemented in conjunction with an artificial reality system. Artificial reality is a form of reality that has been adjusted in some manner before presentation to a user, which may include, e.g., a virtual reality (VR), an augmented reality (AR), a mixed reality (MR), a hybrid reality, or some combination and/or derivatives thereof. Artificial reality content may include completely generated content or generated content combined with captured (e.g., real-world) content. The artificial reality content may include video, audio, haptic feedback, or some combination thereof, and any of which may be presented in a single channel or in multiple channels (such as stereo video that produces a three-dimensional effect to the viewer). Additionally, in some embodiments, artificial reality may also be associated with applications, products, accessories, services, or some combination thereof, that are used to, e.g., create content in an artificial reality and/or are otherwise used in (e.g., perform activities in) an artificial reality. The artificial reality system that provides the artificial reality content may be implemented on various platforms, including a head-mounted display (HMD) connected to a host computer system, a standalone HMD, a mobile device or computing system, or any other hardware platform capable of providing artificial reality content to one or more viewers.

The term "processing logic" in this disclosure may include one or more processors, microprocessors, multi-core processors, Application-specific integrated circuits (ASIC), and/or Field Programmable Gate Arrays (FPGAs) to execute operations disclosed herein. In some embodiments, memories (not illustrated) are integrated into the processing logic to store instructions to execute operations and/or store data. Processing logic may also include analog or digital circuitry to perform the operations in accordance with embodiments of the disclosure.

A "memory" or "memories" described in this disclosure may include one or more volatile or non-volatile memory architectures. The "memory" or "memories" may be removable and non-removable media implemented in any method or technology for storage of information such as computer-readable instructions, data structures, program modules, or other data. Example memory technologies may include RAM, ROM, EEPROM, flash memory, CD-ROM, digital versatile disks (DVD), high-definition multimedia/data storage disks, or other optical storage, magnetic cassettes, magnetic tape, magnetic disk storage or other magnetic storage devices, or any other non-transmission medium that can be used to store information for access by a computing device.

Networks may include any network or network system such as, but not limited to, the following: a peer-to-peer network; a Local Area Network (LAN); a Wide Area Network (WAN); a public network, such as the Internet; a private network; a cellular network; a wireless network; a wired network; a wireless and wired combination network; and a satellite network.

Communication channels may include or be routed through one or more wired or wireless communication utilizing IEEE 802.11 protocols, short-range wireless protocols, SPI (Serial Peripheral Interface), I2C (Inter-Integrated Circuit), USB (Universal Serial Port), CAN (Controller Area Network), cellular data protocols (e.g. 3G, 4G, LTE, 5G), optical communication networks, Internet Service Providers (ISPs), a peer-to-peer network, a Local Area Network (LAN), a Wide Area Network (WAN), a public network (e.g. "the Internet"), a private network, a satellite network, or otherwise.

A computing device may include a desktop computer, a laptop computer, a tablet, a phablet, a smartphone, a feature phone, a server computer, or otherwise. A server computer may be located remotely in a data center or be stored locally.

The processes explained above are described in terms of computer software and hardware. The techniques described may constitute machine-executable instructions embodied within a tangible or non-transitory machine (e.g., computer) readable storage medium, that when executed by a machine will cause the machine to perform the operations described. Additionally, the processes may be embodied within hardware, such as an application specific integrated circuit ("ASIC") or otherwise.

A tangible non-transitory machine-readable storage medium includes any mechanism that provides (i.e., stores) information in a form accessible by a machine (e.g., a computer, network device, personal digital assistant, manufacturing tool, any device with a set of one or more processors, etc.). For example, a machine-readable storage medium includes recordable/non-recordable media (e.g., read only memory (ROM), random access memory (RAM), magnetic disk storage media, optical storage media, flash memory devices, etc.).

The above description of illustrated embodiments of the invention, including what is described in the Abstract, is not intended to be exhaustive or to limit the invention to the precise forms disclosed. While specific embodiments of, and examples for, the invention are described herein for illustrative purposes, various modifications are possible within the scope of the invention, as those skilled in the relevant art will recognize.

These modifications can be made to the invention in light of the above detailed description. The terms used in the following claims should not be construed to limit the invention to the specific embodiments disclosed in the specification. Rather, the scope of the invention is to be determined entirely by the following claims, which are to be construed in accordance with established doctrines of claim interpretation.

## Claims

1. A camera module comprising:
a routing substrate having a ground plane coupled between a first side of the routing substrate and a second side of the routing substrate;
an image sensor configured to receive incident image light, wherein the image sensor is electrically coupled to the first side of the routing substrate;
electrical components electrically coupled to the second side of the routing substrate;
molding compound supporting the image sensor and supporting the electrical components; and
an electro-magnetic interference, EMI, shield layer disposed on the molding compound, wherein the EMI shield layer is tied to the ground plane of the routing substrate.

2. The camera module of claim 1, wherein the EMI shield layer includes metal.

3. The camera module of claim 2, wherein the EMI shield layer includes at least one of copper or stainless steel.

4. The camera module of any preceding claim, wherein the EMI shield layer includes:
a first metal adhesion-layer configured to adhere to the molding compound;
a second metal shielding-layer configured to shield the camera module from electro-magnetic interference; and
a third metal protection layer configured to shield the EMI shield layer from an environment of the camera module.

5. The camera module of any preceding claim, wherein:
the ground plane of the routing substrate is exposed on ends of the routing substrate, wherein the EMI shield layer is electrically coupled to the ground plane on ends of the routing substrate, or
the ground plane of the routing substrate is electrically insulated on ends of the routing substrate, wherein the EMI shield layer is electrically coupled to the ground plane through a solder mask on the second side of the routing substrate.

6. The camera module of any preceding claim further comprising:
vias running through the molding compound, wherein the vias electrically couple the ground plane to the EMI shield layer.

7. The camera module of claim 6, wherein at least a portion of the vias are disposed between the electrical components on the second side of the routing substrate.

8. The camera module of any preceding claim further comprising:
wires of a bonded via array, BVA, running through the molding compound, wherein the wires electrically couple the ground plane to the EMI shield layer,
and optionally wherein at least a portion of the wires of the BVA are disposed between the electrical components on the second side of the routing substrate, and wherein the routing substrate includes vias running to the ground plane to support the BVA, the wires of the BVA being inserted and electrically coupled to the vias of the routing substrate.

9. A method of fabricating a camera module comprising:
electrically coupling an image sensor to a first side of a routing substrate having a ground plane disposed between the first side and a second side of the routing substrate; and
depositing an electro-magnetic interference, EMI, shield layer on a molding compound that supports the image sensor and electrical components electrically coupled to a second side of a routing layer,
wherein depositing the EMI shield layer electrically couples the EMI shield layer to the ground plane of the routing substrate.

10. The method of claim 9 further comprising:
singulating, the camera module from other camera modules disposed on a common routing substrate, wherein the singulating exposes the ground plane of the routing substrate on ends of the routing substrate so that the EMI shield layer can be electrically tied to the ground plane of the routing substrate,
and optionally wherein the singulating is caused by a laser singulation technique.

11. The method of claim 9 or claim 10 further comprising:
forming vias in the molding compound prior to depositing the EMI shield layer, wherein the vias run through the molding compound to the ground plane of the routing substrate,
and optionally wherein:
the vias are laser-drilled vias, and/or
depositing the EMI shield layer fills the vias to electrically tie the EMI shield layer to the ground plane.

12. The method of claim 11, plating the vias with an electrical conductor prior to depositing the EMI shield layer, wherein the electrical conductor filling the vias electrically ties the EMI shield layer to the ground plane of the routing substrate.

13. The method of any of claims 9 to 12, wherein depositing the EMI shield layer includes:
depositing the EMI shield layer to cover the molding compound supporting the electrical components coupled to the second side of the routing substrate;
curing the EMI shield layer covering the molding compound supporting the electrical components; and
depositing the EMI shield layer to cover the molding compound supporting the image sensor on the first side of the routing substrate subsequent to curing the EMI shield layer covering the molding compound supporting the electrical components.

14. The method of any of claims 9 to 13 further comprising:
forming a bonded via array, BVA, by inserting wires into vias of the routing substrate prior to depositing the EMI shield layer, wherein the vias are electrically tied to the ground plane of the routing substrate, and wherein depositing the EMI shield layer electrically couples the EMI shield layer to the BVA.

15. The method of any of claims 9 to 14, wherein the EMI shield layer contacts the molding compound.
